(19) **Europäisches Patentamt**

**European Patent Office**

**Office européen des brevets**

(11) **EP 1 662 654 A1**

(12) **DEMANDE DE BREVET EUROPEEN**

(43) Date de publication:
**31.05.2006 Bulletin 2006/22**

(51) Int Cl.:
***H03F 1/30*** (2006.01)

(21) Numéro de dépôt: **05292537.7**

(22) Date de dépôt: **30.11.2005**

(84) Etats contractants désignés:
**AT BE BG CH CY CZ DE DK EE ES FI FR GB GR HU IE IS IT LI LT LU LV MC NL PL PT RO SE SI SK TR**
Etats d'extension désignés:
**AL BA HR MK YU**

(30) Priorité: **30.11.2004 FR 0412703**

(71) Demandeurs:
• **STMicroelectronics (Rousset) SAS**
  **13790 Rousset (FR)**

• **Université de Provence Aix-Marseille 1**
  **13331 Marseille Cedex 3 (FR)**

(72) Inventeurs:
• **Bas, Gilles**
  **30640 Beauvoisin (FR)**
• **Barthelemy, Hervé**
  **83100 Toulon (FR)**

(74) Mandataire: **Bentz, Jean-Paul et al**
**Novagraaf Technologies,**
**122, rue Edouard Vaillant**
**92593 Levallois-Perret Cedex (FR)**

(54) **Circuit amplificateur à transconductance à gain négatif**

(57) L'invention propose un circuit amplificateur (1) à transconductance pour charge capacitive, comprenant :

- un circuit RC série connecté entre une borne d'entrée (E) et une borne intermédiaire (A);
- un étage d'amplification connecté entre la borne intermédiaire et une borne de sortie (S) connectée à une charge capacitive, et comprenant :

- un premier amplificateur (2) à transconductance à gain négatif connecté en boucle ouverte entre la borne intermédiaire et la borne de sortie ;
- un second amplificateur (3) à transconductance à gain négatif présentant des caractéristiques sensiblement identiques à celles du premier amplificateur, connecté en boucle fermée, son entrée et sa sortie étant connectées à la borne intermédiaire par une résistance (R1).

Fig. 3

## Description

L'invention concerne les amplificateurs linéaires, et en particulier les circuits amplificateurs à transconductance de gain négatif.

Le document Patent abstracts of Japan, Vol 014, N°537 (E-1006), du 27 novembre 1990 décrit un circuit amplificateur comprenant un premier inverseur en boucle fermée avec une première résistance, connecté à un second inverseur en boucle ouverte par l'intermédiaire d'une seconde résistance. Les valeurs des première et seconde résistances sont égales.

Ce circuit amplificateur n'est pas optimisé et présente une bande passante limitée.

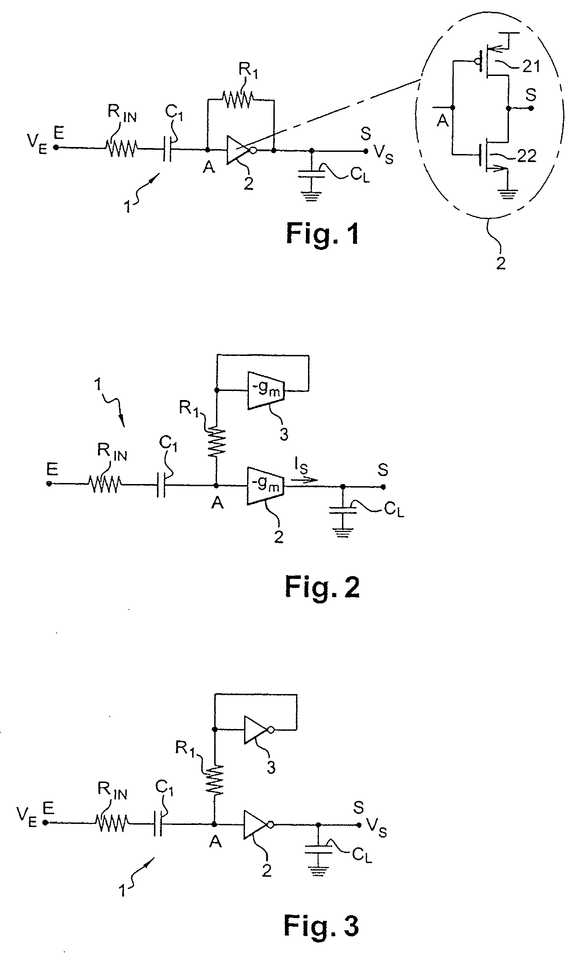

La figure 1 illustre un exemple connu d'amplificateur linéaire intégré 1 couplé à une charge capacitive $C_L$. Le circuit amplificateur 1 comprend un inverseur CMOS 2 décrit notamment dans le brevet US-4 178 605. L'inverseur 2 comprend un transistor PMos 21 et un transistor Nmos22. La source du transistor 21 est connectée à une tension d'alimentation VDD suffisante pour le régime de fonctionnement des transistors 21 et 22. La source du transistor 22 est connectée à la masse. Les grilles des transistors 21 et 22 sont connectées au noeud A de l'inverseur 2. Les drains des transistors 21 et 22 sont connectés à la sortie S du circuit amplificateur 1 et à une charge capacitive $C_L$. De façon connue en soi, le circuit amplificateur 1 présente une résistance R1 connectée entre A et S, une résistance d'entrée Rin et une capacité C1 connectées en série entre l'entrée E et le noeud A.

Lorsque les transistors 21 et 22 présentent une longueur de canal identique ($L_P$ et $L_N$), l'auto-polarisation de l'inverseur 2 aboutira à une tension statique de polarisation au noeud A de l'ordre de VDD/2 si la condition suivante est vérifiée :

$$W_P / W_N = \mu_N / \mu_P$$

$W_P$ et $W_N$ étant les largeurs respectives des canaux des transistors 21 et 22, $\mu_P$ et $\mu_N$ étant leurs mobilités respectives.

Au point de polarisation $V_A = V_S = V_{DD}/2$, les transistors 21 et 22 fonctionnent en régime de saturation. L'amplitude du transfert en tension $A_V$ du circuit amplificateur 1 dans sa bande passante est alors approximativement la suivante :

$$A_V = V_S / V_E \approx -g_m * (R_0 * R_1) / (R_0 + R_1)$$

$g_m$ étant la somme des transconductances respectives des transistors 21 et 22 ;

$R_0$ étant la résistance de sortie de l'inverseur.

$R_0$ est définie par : $R_0 = 1/(g_{DSN} + g_{DSP})$. $g_{DSP}$ et $g_{DSN}$ sont les conductances de sortie respectives des transistors 21 et 22.

Pour une valeur élevée de Av, l'impédance d'entrée du circuit amplificateur est définie par :

$$Z_E \approx R_{in} - R_1 / A_v$$

Pour une valeur élevée de Av, l'impédance de sortie du circuit amplificateur est définie par :

$$Z_S \approx R_1 * R_0 / (R_1 + R_0)$$

Pour une valeur élevée de $A_V$, la fréquence de coupure basse Fcb et la fréquence de coupure haute Fch sont définies respectivement par les formules suivantes :

$$Fcb \approx -A_V / (2\pi * R_1 * C_1)$$

$$Fch \approx 1/(2\pi *(R_1 *R_0)/( R_1 +R_0)*C_L)$$

Il existe en pratique un besoin pour un transfert en tension du circuit amplificateur accru, pour des impédances d'entrée et de sortie accrues et pour une fréquence de coupure basse réduite (à produit gain par bande passante équivalent).

L'invention vise à résoudre un ou plusieurs de ces inconvénients. L'invention porte ainsi sur un circuit amplificateur à transconductance à gain négatif pour charge capacitive, comprenant :

- un circuit RC série connecté entre une borne d'entrée du circuit amplificateur et une borne intermédiaire;
- un étage d'amplification connecté entre la borne intermédiaire et une borne de sortie destinée à être connectée à une charge capacitive, et comprenant :

- un premier amplificateur à transconductance à gain négatif connecté en boucle ouverte entre la borne intermédiaire et la borne de sortie ;
- un second amplificateur à transconductance à gain négatif présentant des caractéristiques sensiblement identiques à celles du premier amplificateur, connecté en boucle fermée, son entrée et sa sortie étant connectées à la borne intermédiaire par une résistance.

Selon une variante, le second amplificateur est configuré pour imposer une tension statique de polarisation du premier amplificateur sur la borne intermédiaire égale à la moitié de la tension d'alimentation du premier amplificateur.

Selon encore une variante, le circuit amplificateur comprend une charge capacitive connectée à la borne de sortie.

Selon encore une autre variante, les premier et second amplificateurs à transconductance à gain négatif comprennent un transistor NMos et un transistor PMos dont les grilles sont connectées à l'entrée de l'amplificateur et dont les drains sont connectés à la sortie de l'amplificateur, la source du transistor PMos étant connectée à une tension d'alimentation et la source du transistor NMos étant connectée à une tension de masse.

On peut alors prévoir que les transistors NMos des premier et second amplificateurs présentent une longueur de canal sensiblement identique, une largeur de canal sensiblement identique et une mobilité sensiblement identique et que les transistors PMos des premier et second amplificateurs présentent une longueur de canal sensiblement identique, une largeur de canal identique et une mobilité identique.

Selon une variante, les transistors PMos et les transistors NMos sont appairés.

Selon encore une variante, la résistance entre la borne intermédiaire et l'entrée du second amplificateur comprend un transistor maintenu passant par une tension de polarisation statique.

L'invention porte également sur un circuit d'amplification, comprenant:

- le circuit amplificateur dans lequel les premier et second amplificateurs à transconductance à gain négatif comprennent un transistor NMos et un transistor PMos ;
- un circuit appliquant un signal de test sur la borne d'entrée du circuit amplificateur ;
- un compteur s'incrémentant en l'absence de signal de blocage ;
- une source de courant appliquant une intensité sur la source du transistor PMos du premier amplificateur, l'intensité appliquée croissant avec l'incrémentation du compteur ;
- un comparateur présentant une première entrée connectée à la borne de sortie du circuit amplificateur et une seconde entrée recevant un niveau de référence, le comparateur appliquant un signal de blocage sur le compteur lorsque le niveau de la première entrée est supérieur au niveau de la seconde entrée.

L'invention porte encore sur un circuit de réception radiofréquences présentant une chaîne de réception homodyne munie d'un mélangeur, et un tel circuit d'amplification dont la borne d'entrée est connectée à la sortie du mélangeur.

D'autres caractéristiques et avantages de l'invention ressortiront clairement de la description qui en est faite ci-après, à titre indicatif et nullement limitatif, en référence aux dessins annexés, dans lesquels :

- la figure 1 illustre un exemple de circuit amplificateur de transconductance à gain négatif selon l'art antérieur ;
- la figure 2 illustre un exemple de circuit amplificateur de transconductance à gain négatif selon l'invention ;
- la figure 3 illustre une première variante du circuit amplificateur de la figure 2 ;
- la figure 4 illustre une seconde variante du circuit amplificateur de la figure 2 ;
- la figure 5 compare les amplitudes de transfert de tension à vide entre les circuits amplificateurs des figures 1 et 3 ;

- la figure 6 compare les amplitudes de transfert de tension sous charge capacitive des circuits amplificateurs des figures 1 et 3 ;
- la figure 7 compare les réponses transitoires à vide des circuits amplificateurs des figures 1 et 3 dans leur bande passante ;
- la figure 8 illustre un exemple de circuit intégrant des circuits amplificateurs selon l'invention ;
- la figure 9 illustre une chaîne d'émission/réception intégrant le circuit de la figure 8.

L'invention propose un circuit amplificateur à transconductance à gain négatif pour charge capacitive présentant un étage d'amplification modifié. Un premier amplificateur à transconductance à gain négatif est destiné à amplifier le signal d'entrée et est connecté en boucle ouverte. Un second amplificateur présentant des caractéristiques sensiblement identiques à celles du premier est connecté en boucle fermée et son entrée et sa sortie sont connectées à l'entrée du premier amplificateur par une résistance.

La valeur absolue du gain d'amplification est ainsi accrue, la dimension de la charge capacitive peut être accrue pour un gain donné, la fréquence de coupure basse de l'amplificateur est abaissée et le niveau de distorsion et le produit gain par bande passante est conservé. Le circuit selon l'invention combine ainsi les avantages d'un amplificateur en boucle ouverte et les avantages d'un amplificateur en boucle fermée.

La figure 2 représente un exemple de circuit amplificateur selon l'invention. Un circuit RC série est connecté entre une borne d'entrée E et une borne intermédiaire A. La capacité $C_1$ permet de filtrer la composante continue du signal appliqué sur la borne E. L'étage d'amplification, connecté entre la borne intermédiaire A et une borne de sortie S, comprend un premier amplificateur à transconductance à gain négatif 2 connecté en boucle ouverte entre les bornes A et S. L'étage d'amplification comprend également un second amplificateur à transconductance à gain négatif 3 connecté en boucle fermée, son entrée et sa sortie étant connectées à la borne A par l'intermédiaire de la résistance R1. L'amplificateur 3 présente des caractéristiques sensiblement identiques à celles de l'amplificateur 2. Les amplificateurs présentent donc un même mode commun. Une charge capacitive $C_L$ est connectée entre la borne de sortie S et une masse.

L'amplificateur 3 est configuré pour imposer une tension statique de polarisation de l'amplificateur 2 égale à la moitié de la tension d'alimentation de cet amplificateur 2. Autour de ce point de polarisation, l'amplificateur 2 se comporte comme une source de courant contrôlée en tension.

On entend par caractéristiques sensiblement identiques des amplificateurs 2 et 3 une technologie identique, des composants sensiblement identiques et présentant la même structure et de mêmes niveaux de tension. Les amplificateurs 2 et 3 illustrés ne diffèrent donc que par les connexions de leurs entrées et leurs sorties.

Le circuit de la figure 3 utilise des amplificateurs 2 et 3 comprenant chacune un inverseur CMOS. Comme dans l'exemple de la figure 1, chaque inverseur CMOS comprend un transistor NMos et un transistor PMos dont les grilles sont connectées à l'entrée de l'amplificateur, dont les drains sont connectés à la sortie de l'amplificateur, la source du transistor PMos étant connectée à une tension d'alimentation $V_{DD}$ et la source du transistor NMos étant connectée à la masse.

Les transistors NMos des amplificateurs 2 et 3 présentent une longueur de canal identique, une largeur de canal identique et une mobilité identique aux dispersions de fabrication près. De même, les transistors PMos des amplificateurs 2 et 3 présentent une longueur de canal identique, une largeur de canal identique et une mobilité identique aux dispersions de fabrication près. De préférence, les transistors NMos des amplificateurs 2 et 3, sont appairés pour améliorer l'adaptation de leurs modes communs et ainsi accroître la valeur absolue du gain d'amplification. De même, les transistors PMos de ces amplificateurs sont appairés.

Le circuit amplificateur présente alors les caractéristiques suivantes pour $|A_V| \gg 1$:

$$A_V \approx -g_m * R_0$$

Par rapport à la solution de la figure 1, le gain est donc théoriquement accru de l'ordre de $(R_0+R_1)/R_1$.

Les impédances d'entrée et de sortie dans la bande passante sont définies par les formules suivantes :

$$Z_E = R_I + (R_M // C_G)$$

$$Z_S = R_0$$

$R_M$ étant la définie par $1/(g_mN + g_mP)$, $g_mN$ et $g_mP$ étant les transconductances de sortie respectives des transistors NMos et PMos en régime de saturation, $C_G$ étant la capacité parasite d'entrée des amplificateurs 2 ou 3, $(R_M//C_G)$ étant l'impédance équivalente à la mise en parallèle de $R_M$ et $C_G$.

Les fréquences de coupure basse et haute (pour $R_0 >> R_M$) sont alors définies par :

$$Fcb \approx 1/(2\pi * R_1 * C_1)$$

$$Fch \approx 1/(2\pi * R_0 * C_L)$$

La fréquence de coupure basse est donc approximativement réduite d'un facteur sensiblement égal à l'amplitude de transfert en tension $A_V$.

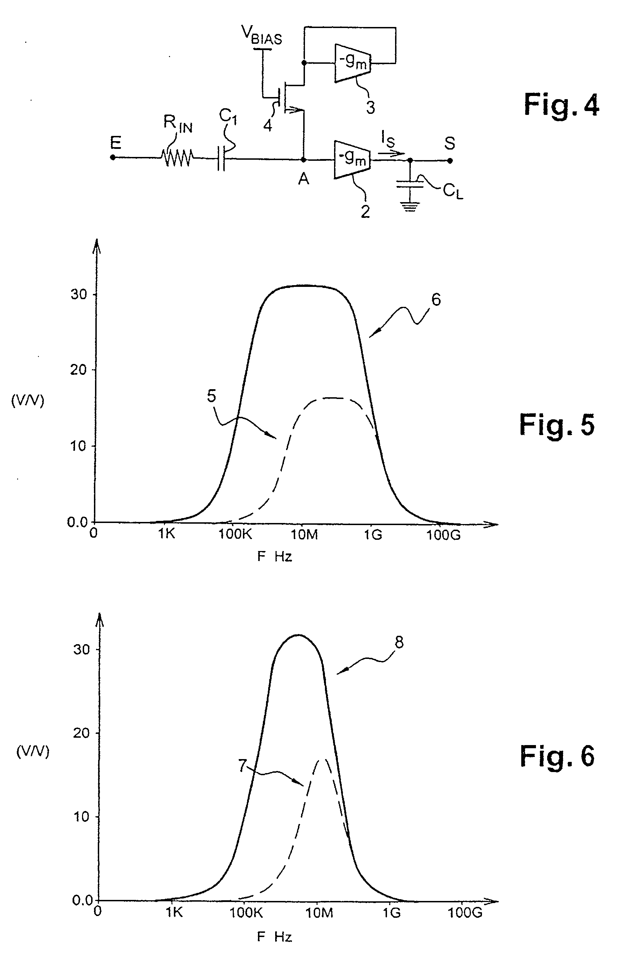

De préférence, la résistance R1 est constituée d'un transistor 4 connecté entre la borne A et l'entrée de l'amplificateur 3. Le transistor est maintenu passant en régime linéaire par une tension de polarisation statique. Le transistor 4 est par exemple un transistor NMos ou PMos. Dans l'exemple de la figure 4, la grille du transistor 4 est alimentée par une tension Vbias, la source du NMos est connectée à la borne A et son drain est connecté à l'entrée et à la sortie de l'amplificateur 3.

Des comparatifs de performance entre les amplificateurs des figures 1 et 3 ont été simulés et sont illustrés sur les figures 5 à 7. Les paramètres utilisés pour la simulation ont été les suivants :

R1=30kΩ, Rin=200Ω et C1=20pF ;
$W_N/L_N=3$, $\mu_N=0{,}35$; $W_P/L_P=9$, $\mu_P=0{,}35$;

| Paramètres | Topologie Proposée | Topologie de la Fig.1 Ref. [1] | Unité |
|---|---|---|---|
| Tension d'alimentation $V_{DD}$ | 2.5 | | V |
| Tension d'alimentation $V_{SS}$=gnd | 0 | | V |
| Tension de polarisation en sortie | 1.285 | | V |
| Transconductance du NMOS ($g_{mN}$) | 814.4μ | | $\Omega^{-1}$ |
| Conductances du NMOS ($g_{DSN}$) | 25μ | | $\Omega^{-1}$ |
| Transconductance du PMOS ($g_{mP}$) | 950μ | | $\Omega^{-1}$ |
| Conductances du PMOS ($g_{DSP}$) | 30μ | | $\Omega^{-1}$ |
| | | | |
| Impédance d'entrée dans la bande (module) | 30k | 1.7k | Ω |
| Résistance de sortie | 19.48k | 10.47k | Ω |
| Taux de distorsion harmonique total (1Vcc en sortie à vide) | 5.5 | 3.94 | % |
| Consommation totale | 1927 | 964 | μW |
| | | | |
| *Simulation à vide $C_L$~16fF* | | | |
| Gain en tension $V_S/V_E$ dans la bande | -31.5 | -16.7 | V/V |
| Produit (CainXBande passante) (-3dB) | 17.2 | 16 | GHz |
| Fréquence de coupure basse (-3dB) | 0.251 | 4.62 | MHz |
| Fréquence de coupure Haute (-3dB) | 549 | 965 | MHz |

Suite de tableau

| Paramètres | Topologie Proposée | Topologie de la Fig.1 Ref. [1] | Unité |
|---|---|---|---|
| *Simulation pour CL=0.5pF* | | | |
| Gain en tension $V_S/V_E$ dans la bande | -31 | -16.6 | V/V |
| Produit Gain*Bande passante (-3dB) | 504 | 495 | MHz |

La figure 5 compare les amplitudes de transfert de tension à vide. Les courbes 5 et 6 correspondent respectivement aux amplificateurs des figures 1 et 3. On constate que la fréquence basse de coupure de l'amplificateur selon l'invention est sensiblement inférieure à celle de l'amplificateur selon l'art antérieur. L'amplitude maximale de transfert de tension de l'amplificateur selon l'invention est très supérieure à celle de l'amplificateur de l'art antérieur. En outre, le produit gain par bande passante est sensiblement conservé.

La figure 6 compare les amplitudes de transfert de tension avec une charge capacitive. Les courbes 7 et 8 correspondent respectivement aux amplificateurs des figures 1 et 3. On constate encore que la fréquence basse de coupure de l'amplificateur selon l'invention est sensiblement inférieure à celle de l'amplificateur selon l'art antérieur. L'amplitude maximale de transfert de tension de l'amplificateur selon l'invention est encore très supérieure à celle de l'amplificateur de l'art antérieur. Le produit gain par bande passante est également sensiblement conservé.

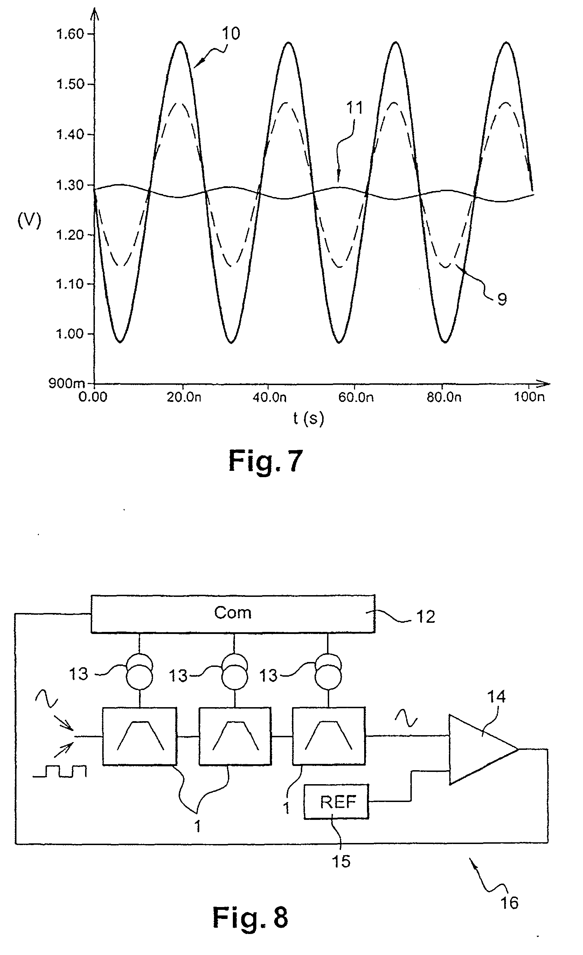

La figure 7 compare les réponses transitoires à vide des amplificateurs des figures 1 et 3. On constate que le circuit amplificateur selon l'invention ne crée pas de distorsions notables sur le signal amplifié par rapport au circuit amplificateur de l'état de la technique.

Bien qu'on ait principalement décrit un exemple de circuit muni d'amplificateurs de type CMOS, l'invention s'applique également à d'autres types d'amplificateurs à transconductance de gain négatif.

Du fait de ses propriétés d'amplification et de filtrage passe-bande, un circuit amplificateur tel que décrit précédemment est avantageusement intégré dans un circuit d'amplification calibrant sa bande passante. La figure 8 illustre un circuit d'amplification 16 à bande passante calibrée intégrant des circuits amplificateurs 1 selon l'invention.

Le circuit 16 comprend un compteur 12 commandant des sources de courant 13. A chaque incrément du compteur 16, la consigne de courant appliquée sur les sources de courant 13 est augmentée. Chaque source de courant 13 est connectée à un circuit amplificateur 1 respectif. Les sorties des circuits amplificateurs 1 sont connectées à une entrée d'un comparateur 14. L'autre entrée du comparateur 14 reçoit une consigne de bande passante fournie par un circuit de référence 15.

En utilisant un circuit amplificateur 1 selon la figure 3, le courant d'une source 13 est injecté sur les sources des transistors PMos des amplificateurs 2 et 3. La bande passante du circuit amplificateur 1 est alors sensiblement proportionnelle au niveau d'intensité appliqué par la source de courant.

La phase de calibrage se déroule de la façon suivante : le compteur est initialement placé à un niveau bas. Le courant appliqué chaque source 13 sur son circuit amplificateur 1 est ainsi faible. La bande passante de chaque circuit amplificateur 1 est ainsi initialement réduite. Un signal de test est appliqué sur la borne d'entrée de chaque circuit amplificateur 1. Le niveau du signal sur la borne de sortie de chaque circuit amplificateur 1 est représentatif de sa bande passante. Tant que le niveau de signal sur la borne de sortie est inférieur à la consigne de bande passante fournie par le circuit 15, le signal de sortie du comparateur commande l'incrémentation du compteur 12. Le compteur 12 s'incrémente et le courant des sources 13 s'accroît en conséquence, jusqu'à ce que le niveau du signal sur une borne de sortie d'un circuit amplificateur 1 dépasse la consigne de bande passante. Le signal de sortie du comparateur commande alors le blocage du compteur 12. La bande passante des circuits amplificateurs 1 est ainsi calibrée.

Le signal de test appliqué sur la borne d'entrée d'un circuit amplificateur est par exemple un signal d'horloge carré. On peut également prévoir d'appliquer un signal de test sinusoïdal dont la fréquence est la fréquence de coupure haute souhaitée. Le calibrage peut être effectué à intervalles réguliers, afin de compenser la dérive des composants des circuits amplificateurs 1.

Pour un circuit amplificateur 1 présentant des amplificateurs à transistors CMOS, la consommation et la taille des transistors peuvent être réduites du fait du calibrage : l'amplificateur ne consommera que le courant correspondant à la bande passante nécessaire calibrée.

Les circuits amplificateurs 1 sont particulièrement adaptés pour une chaîne de réception, puisqu'ils présentent une fréquence de coupure rabaissée, leur bande passante pouvant alors inclure les signaux issus des mélangeurs.

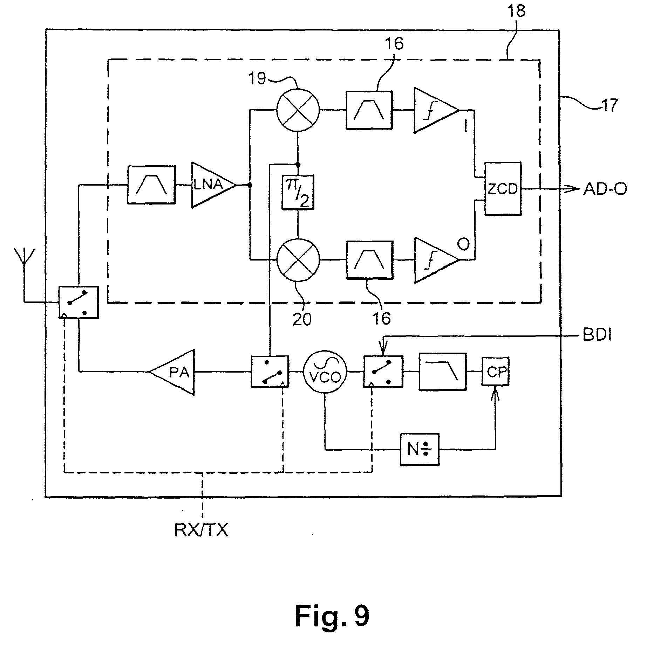

Des circuits d'amplification 16 sont ainsi avantageusement intégrés dans une chaîne de réception homodyne. La figure 9 illustre un circuit de communication radiofréquences 17 présentant une chaîne de réception homodyne 18 munie de mélangeurs 19 et 20. La sortie de chaque mélangeur est connectée à la borne d'entrée d'un circuit amplificateur 1 d'un circuit d'amplification 16.

Le calibrage de la bande passante d'un circuit amplificateur peut être effectué à intervalles réguliers, par exemple à chaque seconde.

**Revendications**

1. Circuit amplificateur (1) à transconductance à gain négatif pour charge capacitive, comprenant :

   - un circuit RC série connecté entre une borne d'entrée (E) du circuit amplificateur et une borne intermédiaire (A);
   - un étage d'amplification connecté entre la borne intermédiaire et une borne de sortie (S) destinée à être connectée à une charge capacitive ;
   **caractérisé en ce que** l'étage d'amplification comprend :
   - un premier amplificateur (2) à transconductance à gain négatif connecté en boucle ouverte entre la borne intermédiaire et la borne de sortie ;
   - un second amplificateur (3) à transconductance à gain négatif présentant des caractéristiques sensiblement identiques à celles du premier amplificateur, connecté en boucle fermée, son entrée et sa sortie étant connectées à la borne intermédiaire par une résistance (R1, 4).

2. Circuit amplificateur (1) selon la revendication 1, **caractérisé en ce que** le second amplificateur (3) est configuré pour imposer une tension statique de polarisation du premier amplificateur sur la borne intermédiaire (A) égale à la moitié de la tension d'alimentation du premier amplificateur (2).

3. Circuit amplificateur selon la revendication 1 ou 2, **caractérisé en ce qu'**il comprend une charge capacitive ($C_L$) connectée à la borne de sortie (S).

4. Circuit amplificateur selon l'une quelconque des revendications précédentes, **caractérisé en ce que** les premier et second amplificateurs (2, 3) à transconductance à gain négatif comprennent un transistor NMos et un transistor PMos dont les grilles sont connectées à l'entrée de l'amplificateur et dont les drains sont connectés à la sortie de l'amplificateur, la source du transistor PMos étant connectée à une tension d'alimentation et la source du transistor NMos étant connectée à une tension de masse.

5. Circuit amplificateur selon la revendication 4, **caractérisé en ce que** :

   - les transistors NMos des premier et second amplificateurs présentent une longueur de canal sensiblement identique, une largeur de canal sensiblement identique et une mobilité sensiblement identique ;
   - les transistors PMos des premier et second amplificateurs présentent une longueur de canal sensiblement identique, une largeur de canal identique et une mobilité identique.

6. Circuit amplificateur selon la revendication 4 ou 5, **caractérisé en ce que** les transistors PMos et les transistors NMos sont appairés.

7. Circuit amplificateur selon l'une quelconque des revendications précédentes, **caractérisé en ce que** la résistance entre la borne intermédiaire et l'entrée du second amplificateur comprend un transistor (4) maintenu passant par une tension de polarisation statique.

8. Circuit d'amplification (16), **caractérisé en ce qu'**il comprend :

   - un circuit amplificateur selon la revendication 4 ou l'une quelconque de ses revendications dépendantes ;
   - un circuit appliquant un signal de test sur la borne d'entrée (E) du circuit amplificateur ;
   - un compteur (12) s'incrémentant en l'absence de signal de blocage ;
   - une source de courant (13) appliquant une intensité sur la source du transistor PMos du premier amplificateur (2), l'intensité appliquée croissant avec l'incrémentation du compteur ;
   - un comparateur (14) présentant une première entrée connectée à la borne de sortie du circuit amplificateur et une seconde entrée recevant un niveau de référence, le comparateur appliquant un signal de blocage sur le compteur (12) lorsque le niveau de la première entrée est supérieur au niveau de la seconde entrée.

9. Circuit de réception radiofréquences (17) présentant une chaîne de réception homodyne (18) munie d'un mélangeur (19, 20), **caractérisé en ce qu'**il comprend en outre un circuit d'amplification selon la revendication 8 dont la borne d'entrée est connectée à la sortie du mélangeur.

**Fig. 1**

**Fig. 2**

**Fig. 3**

Fig. 4

Fig. 5

Fig. 6

**Fig. 7**

**Fig. 8**

**Fig. 9**

**Office européen des brevets**

**RAPPORT DE RECHERCHE EUROPEENNE**

Numéro de la demande

EP 05 29 2537

## DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| X | PATENT ABSTRACTS OF JAPAN vol. 014, no. 537 (E-1006), 27 novembre 1990 (1990-11-27) & JP 02 228107 A (DAISHINKU CO), 11 septembre 1990 (1990-09-11) * abrégé; figures 1,2 * | 1,2 | H03F1/30 |
| A | US 2002/153944 A1 (UCHIKI HIDEKI ET AL) 24 octobre 2002 (2002-10-24) * alinéa [0036] - alinéa [0069]; figures 3-10 * | 1,3-6,8 | |
| A | VOO T-F ET AL: "EFFICIENT TUNABLE CONTINUOUS-TIME INTEGRATED CURRENT-MODE FILTER DESIGNS" 1996 IEEE INTERNATIONAL SYMPOSIUM ON CIRCUITS AND SYSTEMS (ISCAS). CIRCUITS AND SYSTEMS CONNECTING THE WORLD. ATLANTA, MAY 12 - 15, 1996, IEEE INTERNATIONAL SYMPOSIUM ON CIRCUITS AND SYSTEMS (ISCAS), NEW YORK, IEEE, US, vol. VOL. 1, 12 mai 1996 (1996-05-12), pages 93-96, XP000825523 ISBN: 0-7803-3074-9 * page 93; figure 1 * | 7 | |
| A | TELLI A ET AL: "CMOS LNA design for Leo space s-band applications" CCECE 2003. CANADIAN CONFERENCE ON ELECTRICAL AND COMPUTER ENGINEERING. MONTREAL, CANADA, MAY 4 - 7, 2003, CANADIAN CONFERENCE ON ELECTRICAL AND COMPUTER ENGINEERING, NEW YORK, NY : IEEE, US, vol. VOL. 3 OF 3, 4 mai 2003 (2003-05-04), pages 27-30, XP010653987 ISBN: 0-7803-7781-8 * page 27; figure 1 * | 1,9 | |

**DOMAINES TECHNIQUES RECHERCHES (IPC)**

H03F

Le présent rapport a été établi pour toutes les revendications

| Lieu de la recherche | Date d'achèvement de la recherche | Examinateur |
|---|---|---|
| La Haye | 7 février 2006 | Fedi, G |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons
.......................................................................
& : membre de la même famille, document correspondant

EPO FORM 1503 03.82 (P04C02)

**ANNEXE AU RAPPORT DE RECHERCHE EUROPEENNE
RELATIF A LA DEMANDE DE BREVET EUROPEEN NO.**

EP 05 29 2537

La présente annexe indique les membres de la famille de brevets relatifs aux documents brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

07-02-2006

| Document brevet cité au rapport de recherche | Date de publication | Membre(s) de la famille de brevet(s) | Date de publication |
|---|---|---|---|
| JP 02228107 A | 11-09-1990 | AUCUN | |
| US 2002153944 A1 | 24-10-2002 | CN 1381947 A<br>DE 10211891 A1<br>JP 2002314399 A | 27-11-2002<br>05-12-2002<br>25-10-2002 |

EPO FORM P0460